Europäisches Patentamt

(19) European Patent Office

Office européen des brevets

(11) Numéro de publication: **0 180 268**

**B1**

(12) **FASCICULE DE BREVET EUROPÉEN**

(45) Date de publication du fascicule du brevet:
28.02.90

(21) Numéro de dépôt: 85201599.9

(22) Date de dépôt: 03.10.85

(51) Int. Cl. ⁵: **H 01 L 21/318, H 01 L 21/324,**
**H 01 L 29/62, C 23 C 16/34**

(54) Procédé de réalisation d'un dispositif semiconducteur incluant l'action de plasma.

(30) Priorité: 09.10.84 FR 8415484

(43) Date de publication de la demande:
07.05.86 Bulletin 86/19

(45) Mention de la délivrance du brevet:
28.02.90 Bulletin 90/09

(84) Etats contractants désignés:
DE FR GB NL

(56) Documents cité:
US-A-4 448 633

JOURNAL OF THE ELECTROCHEMICAL SOCIETY,
vol. 129, no. 4, avril 1982, pages 821-824, Manchester,
New Hampshire, US; F. CAPASSO et al.: "A proposed
hydrogenation/nitridization passivation mechanism
for GaAs and other III-V semiconductor devices,
including InGaAs long wavelength photodetectors"

APPLIED PHYSICS LETTERS, vol. 42, no. 6, 15 mars
1983, American Institute of Physics, pages 509-511,
New York, US; P. FRIEDEL et al.: "Interactions
between H2 and N2 plasmas and a GaAs(100) surface:
Chemical and electronic poroperties"

IEEE ELECTRON DEVICE LETTERS, vol. EDL-3, no. 3,
mars 1982, IEEE, pages 56-58, New York, US; T.Y.
CHANG et al.: "Junction field-effect transistors using
In0.53Ga0.47As material grown by molecular beam
epitaxy"

(73) Titulaire: LABORATOIRES D'ELECTRONIQUE PHILIPS
3, Avenue Descartes
F-94450 Limeil-Brévannes (FR)
(84) Etats contractants désignés: FR

(73) Titulaire: N.V. Philips' Gloeilampenfabrieken
Groenewoudseweg 1
NL-5621 BA Eindhoven (NL)
(84) Etats contractants désignés: DE GB NL

(72) Inventeur: Gourrier, Serge
Société Civile S.P.I.D. 209 rue de l'Université
F-75007 Paris (FR)
Inventeur: Theeten, Jean-Bernard
Société Civile S.P.I.D. 209 rue de l'Université
F-75007 Paris (FR)

(74) Mandataire: Landousy, Christian
Société Civile S.P.I.D. 209, Rue de l'Université
F-75007 Paris (FR)

㉝ Documents cité (suite):
APPLIED PHYSYCS LETTERS, vol. 37, no. 5, 1
septembre 1980, American Institute of Physics, pages
473-475, New York, US; V. EU et al.: "Cr profiles in semiinsulating GaAs after annealing with and without SiO2
encapsulats in a H2-As4 atmosphere"

APPLIED PHYSICS LETTERS, vol. 44, no. 7, 1 avril 1984,
American Institute of Physics, pages 684-686, New
York, US; S.J. PEARTON et al.: "Nitridization of gallium
arsenide surfaces: effects on diode leakage currents"

2

## Description

L'invention concerne un procédé de réalisation d'un dispositif semiconducteur, procédé comprenant d'abord une étape de traitement de surface par plasma d'un substrat en un matériau III - V contenant au moins l'arsenic et le gallium, et comprenant ensuite une étape de dépôt, également par plasma, sur la surface traitée, d'une couche de nitrure de silicium (Si₃N₄).

Ce procédé trouve son application dans la préparation de la surface d'un substrat, par exemple d'arséniure de gallium avant l'élaboration d'un dispositif, ou bien dans la passivation des surfaces, par exemple de l'arséniure de gallium, en cours ou en fin d'élaboration d'un dispositif.

Un tel procédé est connu de l'art antérieur par la publication de Marion D. Clark et C. Lawrence Anderson dans J. Vac. Sci. technol., 21(2), juillet/août 1982, intitulée "Improvements in GaAs/plasma deposited silicon nitride interface quality by predeposition GaAs surface treatment and postdeposition annealing".

Ce document décrit un procédé pour améliorer la qualité du dépôt de couches de nitrure de silicium (Si₃N₄) sur un substrat en arséniure de gallium monocristallin préalablement poli, dans le but d'améliorer la qualité de structures capacitives. Une amélioration de l'interface GaAs-Si₃N₄ est obtenue par un traitement du substrat d'arséniure de gallium avant dépôt de la couche de nitrure. Ce traitement comprend une première étape pendant laquelle le substrat est soumis à un plasma d'azote servant à dégazer la chambre du réacteur, et une seconde étape pendant laquelle le substrat est soumis à un plasma d'hydrogène servant à réduire les oxydes natifs à la surface de l'arséniure de gallium. La couche de nitrure de silicium est ensuite déposée par plasma de silane et d'azote (SiH₄+N₂). Le dépôt est suivi d'un recuit vers 600°C. Des structures de capacités sont réalisées à partir de ce dispositif en divisant le substrat selon des dimensions convenables puis en réalisant des contacts ohmiques dans l'ouverture de masques appropriés.

Mais dans l'application à la réalisation d'éléments actifs tels que des transistors à effet de champ ou des diodes sur un composé III - V contenant l'arsenic et le gallium, ce procédé présente de nombreux inconvénients.

D'abord, le traitement d'un substrat en un tel composé par un plasma d'hydrogène, conduit à la formation d'hydrure volatil et appauvrit la surface en arsenic. Cet effet est connu, particulièrement du brevet US-4 631 461, colonne 4, ligne 36. L'appauvrissement en arsenic est donné de l'ordre de 3 à 8 % pour l'arséniure de gallium. La composition stoechiométrique du composé n'étant pas conservée, les propriétés électriques du dispositif actif élaboré à partir de sa surface sont différentes des propriétés attendues.

Ensuite, le but du traitement, qui est l'élimination des oxydes gênants, n'est pas entièrement atteint, comme il est montré figure 5 et figure 6 de la publication M. D. Clark et C. L. Anderson citée.

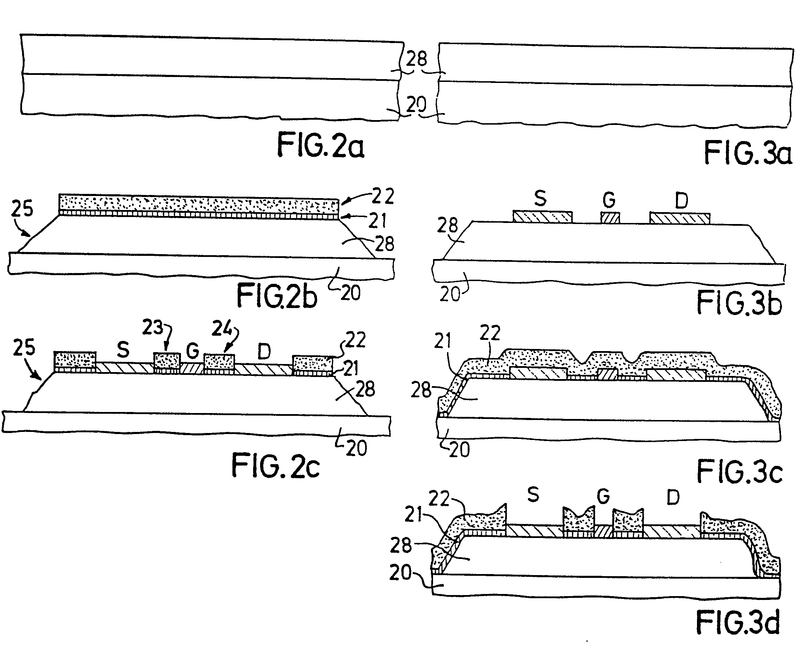

En outre, le recuit à 600°C joue un grand rôle dans l'obtention de l'amélioration de la qualité de l'interface semiconducteur-couche de nitrure comme il est montré sur la figure 3 de ce même document. Or une température aussi élevée doit impérativement être évitée, lors de l'élaboration d'éléments actifs, du fait que l'arsenic contenu dans le substrat devient volatil à partir de 450°C.

Le procédé proposé par le document cité peut donc être utilisé pour réaliser une couche diélectrique utile à l'élaboration d'un dispositif passif, mais non pas pour réaliser la couche de passivation d'un dispositif actif.

C'est pourquoi, la présente invention vise à fournir un procédé de réalisation d'un tel dispositif par lequel ces inconvénients sont évités.

Selon l'invention le but est atteint à l'aide d'un procédé tel que défini dans le préambule caractérisé en ce que dans l'étape de traitement de surface par plasma, ce traitement de surface par plasma est obtenu par la réaction d'un composé gazeux formé d'hydrogène et d'arsenic, à une température inférieure à 450°C, cette réaction consistant à réduire les oxydes natifs, à éliminer des impuretés telles que le carbone et à reconstituer la composition stoechiométrique du matériau III - V par recombinaison de l'arsenic en surface, en ce que l'étape de dépôt de nitrure de silicium par plasma, est précédée par une étape de formation d'une couche mince de nitrure d'arsenic et de gallium par plasma d'azote (N₂), cette couche servant de couche de passivation, et en ce que toute les étapes incluant des plasmas sont réalisées dans une même enceinte et contrôlées sans sortir l'échantillon de l'enceinte.

Dans ces conditions, l'action du plasma d'hydrogène et d'arsenic permet d'éliminer complètement la couche d'oxyde située en surface du matériau sans être pénalisé par un appauvrissement en arsenic. Les impuretés autres que l'oxygène sont également éliminées. La surface peut être considérée comme absolument propre sans être détériorée.

D'autre part, la couche de nitrure d'arsenic et de gallium constitue à elle seule la couche de passivation, la couche de nitrure de silicium servant alors soit de diélectrique, soit de protection mécanique.

Dans une mise en oeuvre de l'invention, ce procédé est caractérisé en ce que, le matériau III - V étant l'arséniure de gallium (GaAs), le composé gazeux d'hydrogène et d'arsenic est un mélange d'hydrogène et d'arsine (H₂ + AsH₃), dans lequel la quantité d'arsine est inférieure à ou de l'ordre de 1 % en volume, en ce que l'action de ce plasma sur la surface d'arséniure de gallium est pratiquée à environ 370°C, en ce que la couche de nitrure d'arsenic et de gallium est réalisée sur une épaisseur d'environ $2.10^{-3}$ $^{e}$m par l'action du plasma d'azote (N₂), et en ce que enfin la couche de nitrure de silicium est obtenue par l'action d'un plasma de silane et d'azote (SiH₄ + N₂).

La description suivante, illustrée par les figures annexées fera mieux comprendre comment l'invention est réalisée.

La figure 1 représente l'appareillage permettant la mise en oeuvre de l'invention.

La figure 2 représente les différentes étapes de la réalisation d'un élément actif semiconducteur dans le cas où le procédé selon l'invention est pratiqué au début de l'élaboration.

La figure 3 représente les différentes étapes de la réalisation d'un élément actif dans le cas où le procédé selon l'invention est pratiqué en fin d'élaboration.

La figure 4 représente les variations de l'intensité du courant de fuite (en ampères) en fonction de la différence de tension grille-source (en volts) dans un transistor à effet de champ réalisé à l'aide du procédé selon l'invention comparées à celles observées dans un transistor non traité.

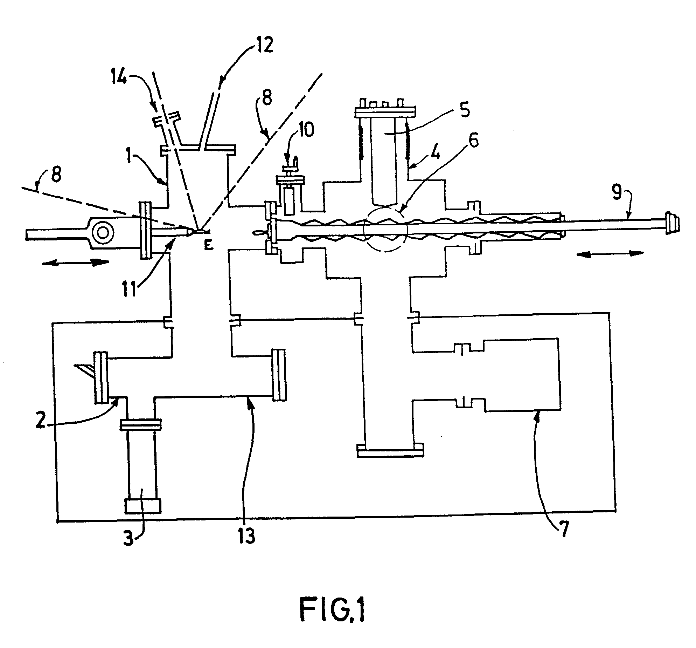

Tel que représenté sur la figure 1, l'appareillage utilisé pour la mise en oeuvre de l'invention comprend d'abord une chambre de traitement 1 portée à un vide d'environ $133.10^{-9}$ Pa par l'action des pompes à diffusion 3 et turbomoléculaire 13, ainsi que d'un piège à ultravide 2. Deux hublots pratiqués dans la chambre de traitement permettent de réaliser des mesures éllipsométriques sur l'échantillon E en place, les faisceaux lumineux étant représentés par les traits pointillés 8. Cet appareillage comprend en outre une chambre de caractérisation 4 permettant d'effectuer des mesures par canon RHEED 6 et spectromètre Auger 5. Le système de transfert de l'échantillon de la chambre de traitement à la chambre de caractérisation comprend une canne de transfert 9, un système de rotation-translation 10 et un porte échantillon 11. La chambre de caractérisation est dotée d'une pompe ionique 7. L'ouverture d'une vanne permet de faire communiquer les deux chambres. Une sonde de Langmuir non représentée est adjointe à la chambre de traitement.

L'arrivée des gaz dans la chambre de traitement se fait en 12 et l'échantillon peut être chauffé par effet Joule. Un pyromètre 14 permet d'en mesurer la température.

Des mesures d'ellipsométrie cinétique permettent de caractériser l'échantillon en cours de dépôt.

Des mesures d'ellipsométrie spectroscopique permettent de connaître au repos des paramètres tels que les constantes diélectriques, l'épaisseur d'isolant.

La diffraction par électrons à haute énergie, à l'aide du canon RHEED, renseigne sur la structure cristalline de la surface de l'échantillon.

La spectroscopie Auger renseigne sur la composition chimique de la surface.

La spectroscopie de masse indique la composition du plasma.

La sonde de Langmuir en précise les différentes caractéristiques physiques.

Un tel appareillage permet la préparation et la caractérisation d'échantillons de matériau III - V destiné à la réalisation de dispositifs semiconducteurs.

Avant toute réalisation de dispositif semiconducteur et particulièrement de dispositifs incluant un matériau III - V, le substrat doit subir une préparation. En effet il a été montré amplement dans les publications parues à ce jour sur le sujet, telles que la publication citée comme art antérieur, ou bien encore dans la publication de Burhan Bayraktaroglu et Robert L. Johnson dans J. Applied PHys. 52 (5) May 1981 intitulée "Silicon-nitride-gallium-arsenide Mis structures produced by plasma enhanced deposition", que l'oxyde natif sur la surface des matériaux III - V incluant l'arsenic et le gallium produit de nombreux inconvénients, en particulier un courant de fuite élevé dans les transistors, et une faible modulation de capacité dans les structures MIS. Les dispositifs semiconducteurs doivent donc toujours être réalisés sur une surface ayant subi un nettoyage préalable, puis être recouvert d'une couche dite de passivation.

Jusqu'à présent les meilleurs résultats pour éliminer l'oxyde natif avaient été obtenus par l'action d'un plasma d'hydrogène ($H_2$) seul. Mais les publications citées montrent qu'il reste encore, à l'analyse au spectromètre Auger un niveau d'oxygène important.

Les mesures réalisées avec l'appareillage décrit précédemment, lors des recherches concourant à la présente invention, ont montré que seul l'oxyde d'arsenic est éliminé par le plasma d'hydrogène.

L'oxyde de gallium n'est pas éliminé et de plus la composition chimique de la surface est appauvrie en arsenic dans des proportions pouvant aller jusqu'à 8 %, ce qui change considérablement les propriétés électriques attendues pour un élément actif réalisé avec le matériau ainsi préparé.

Selon une réalisation préférée de l'invention, une quantité d'arsine ($AsH_3$) en proportion de l'ordre de 0,3 % de l'hydrogène est ajoutée à ce dernier lors du traitement d'une surface d'arséniure de gallium. Les mesures au spectromètre Auger montrent que d'une part l'oxyde de gallium est alors réduit et que d'autre part la composition stoéchiométrique de l'arséniure de gallium en surface est rétablie. De plus des impuretés telles que le carbone sont éliminées.

La surface peut alors être considérée comme absolument propre.

Mais il faut alors éviter une pollution ultérieure de la surface ainsi préparée.

A cet effet l'art antérieur proposait la passivation par une couche de nitrure de silicium. Mais la publication de D. Clark et CL. Anderson montre que la couche de nitrure de silicium contient elle-même de l'oxygène.

C'est pourquoi la présente invention propose de former in situ à la suite de l'opération de nettoyage par plasma d'hydrogène et d'arsine, une couche protectrice fine de nitrure d'arsenic et de gallium. Cette couche peut être faite de façon simple par l'action d'un plasma d'azote ($N_2$) immédiatement après l'opération de nettoyage. Une couche de l'ordre de $2.10^{-3}$ µm suffit à assurer la véritable passivation de la surface.

La couche de nitrure de silicium n'est ensuite réalisée qu'à titre de protection mécanique, électrique, ou comme diélectrique.

L'avantage principal présenté par le procédé selon l'invention est que toutes les opérations sont réalisées par plasma, dans une même enceinte et contrôlées sans sortir l'échantillon de l'enceinte.

Les exemples suivants montrent que les inconvénients inhérents à l'art antérieur sont évités : le courant de fuite dans un dispositif actif est diminué, les propriétés électriques sont conservées, tous les résultats sont reproductibles.

## Exemple I

L'échantillon est un substrat monocristallin d'arséniure de gallium de type n (niveau de dopage $\simeq 10^{18}.cm^{-3}$).

Après introduction dans la chambre de traitement de l'appareillage, il est caractérisé par spectroscopie Auger et ellipsométrie spectroscopique. Les mesures montrent la présence d'une fine couche d'oxyde natif et une contamination carbonée.

L'échantillon est alors soumis à un plasma multipolaire d'un mélange d'hydrogène et d'arsine, dans les conditions expérimentales suivantes :

– Pression totale $\simeq 133.10^{-3}$ Pa.
– Rapport de la pression partielle d'arsine ($AsH_3$) à la pression totale : environ 3 pour mille.
– Température de l'échantillon : environ 380°C.
– Densité du plasma de l'ordre de $10^{10}.cm^{-3}$.

L'action du plasma sur l'échantillon est suivie par ellipsométrie. Elle se déroule en deux étapes. La première étape est l'élimination de la contamination carbonée et de l'oxyde d'arsenic. La seconde étape est la réduction de l'oxyde gallium.

L'analyse au spectromètre Auger permet ensuite de contrôler la complète absence d'oxygène de la surface de l'échantillon à ce stade.

L'échantillon est ensuite soumis à un plasma d'azote dans les conditions expérimentales suivantes:

– Pression totale $\simeq 133.10^{-3}$ Pa.
– Température ambiante.
– Densité du plasma $\simeq 10^{10}.cm^{-3}$.

Le contrôle ellipsométrique montre alors la formation d'une fine couche (1,5 à $2.10^{-3}$ µm) de diélectrique. Des analyses en photoémission montrent que cete couche est formée du mélange de nitrures d'arsenic et de gallium.

L'échantillon est ensuite recouvert d'une couche d'environ 0,1 µm de nitrure de silicium formé par dépôt en phase vapeur assisté par plasma dans la même chambre, dans les conditions expérimentales suivantes:
– Mélange silane + azote ($SiH_4 + N_2$)
– Rapport des débits d'azote par rapport au silane $\simeq 25$.
– Température ambiante.
– Vitesse de dépôt $\simeq 2.10^{-3}$ µm/minute.

L'échantillon peut alors être sorti de la chambre traitement de l'appareillage et caractérisé:

– le rendement de photoluminescence de la surface traitée par plasma ($AsH_3 + H_2$) selon le procédé décrit est environ trois fois plus grand que si l'échantillon n'avait subi qu'un traitement au plasma d'hydrogène seul ($H_2$). Ceci correspond à une vitesse de recombinaison environ 10 fois plus faible et montre bien l'intérêt de l'addition d'arsine dans le plasma de traitement.

Des structures MIS (Métal-Isolant-Semiconductor) ont été réalisées sur des échantillons traités selon le procédé décrit plus haut. L'analyse des propriétés électriques telles que:

– la capacité en fonction de la tension appliquée;
– la conductance en fonction de la tension appliquée

a montré que la répartition de densités d'état de surface permet une modulation du niveau de Fermi plus importante (0,8 à 1 eV) que sur des structures MIS non traitées par le procédé selon l'invention (environ 0,4 eV dans ce cas).

## Exemple II (Illustré sur la figure 2)

L'échantillon est un substrat monocristallin 20 d'arséniure de gallium semi-isolant qui a subi l'implantation d'ions silicium et a été recuit de manière à former une couche active 28 de dopage $2,8 \times 10^{17}$ cm$^{-3}$ sur environ 0,25 µm (Figure 2a).

L'échantillon est ensuite traité selon la méthode décrite dans l'exemple I. Puis l'échantillon couvert de nitrure d'arsenic et de gallium 21 et de nitrure de silicium 22 (Figure 2b) est introduit dans un cycle d'opérations technologiques permettant de réaliser des transistors à effet de champ, dont les principales étapes sont les suivantes:

– Ouverture dans le diélectrique (nitrures 21 et 22) de zones permettant de graver dans la couche active et d'isoler ainsi chaque dispositif par formation de mesas 25.
– Ouverture dans le diélectrique, sur chaque mésa, de zones pour les contacts ohmiques de source S et drain D. Réalisation de ces contacts par évaporation d'or et de germanium puis formation de l'alliage.
– Ouverture dans le diélectrique d'une zone de grille G et évaporation dans cette zone d'un métal propre à former le contact de grille, (Figure 3c) par exemple l'aluminium.

On remarquera que les zones d'accès du transistor, 23, et 24, entre la source et la grille d'une part, et entre la grille et le drain d'autre part, sont restées constamment couvertes de diélectrique pendant l'élaboration du transistor à effet de champ.

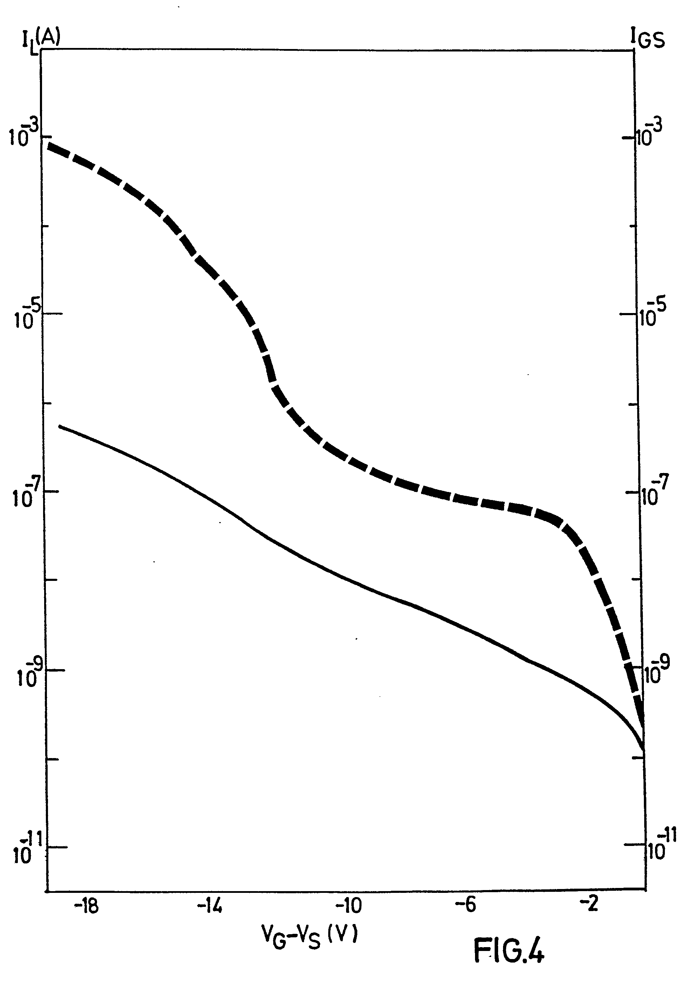

Les caractéristiques électriques de ce transistor ont été ensuite mesurées. Ce transistor montre un courant de fuite représenté en trait plein sur la figure 4, entre grille et source, la source et le drain étant court-circuités, nettement inférieur au courant de fuite, représenté en trait pointillé sur la même figure 4 d'un même transistor obtenu par un procédé selon l'art antérieur. Le transistor selon l'invention montre également une absence totale de dispersion de la transconductance.

Les caractéristiques des transistors à effet de champ bas-bruit en arséniure de gallium considérés, étaient:

– Longueur de grille: 2 μm
– Largeur de grille: 30 μm

**Exemple III** (illustré par la figure 3)

Le traitement décrit dans l'exemple I est appliqué ici à des transistors à effet de champ de puissance en arséniure de gallium, en fin de technologie de réalisation.

Dans ce cas, en effet, après réalisation sur un substrat monocristallin semi-isolant en arséniure de gallium 20, d'une couche active 28 et de mésas 25, figure 3a, les contacts de source S, grille G et drain D sont réalisés directement, les zones d'accès source-grille 23 et grille-drain 24 étant nues (figure 3b).

Le traitement selon l'invention est alors pratiqué à ce stade (figure 3c). Le dépôt de nitrure de silicium se faisant sur l'ensemble du transistor, une étape supplémentaire d'ouverture du diélectrique dans les zones de contact électrique doit alors être prévue (figure 3d).

Avant l'application du procédé selon l'invention à un tel transistor, ce dernier présentait une anomalie assez fréquente dite "Commutation en deux temps" qui consiste dans le fait suivant : le transistor passe de l'état bloqué à l'état passant en deux étapes. Il a été constaté que ce phénomène disparaît par application du procédé à ce transistor.

D'autre part ici encore, le traitement selon l'invention réduit les courants de fuite d'un facteur deux à bas champ et d'un facteur huit à champ fort, la tension grille-source étant d'environ 20 V, et la source et le drain étant reliés. Ce résultat est particulièrement intéressant pour un transistor de puissance.

Il est évident que le procédé selon l'invention peut être appliqué à de nombreux autres dispositifs sans pour autant sortir du cadre de l'invention tel que défini par les revendications ci-après annexées.

**Revendications**

1. Procédé de réalisation d'un dispositif semiconducteur, ce procédé comprenant d'abord une étape de traitement de surface par plasma d'un substrat en un matériau III - V contenant au moins l'arsenic et le gallium, et comprenant ensuite une étape de dépôt également par plasma, sur la surface traitée, d'une couche de nitrure de silicium (Si₃N₄), caractérisé en ce que dans l'étape de traitement de surface par plasma, ce traitement de surface par plasma est obtenu par la réaction d'un composé gazeux formé d'hydrogène et d'arsenic, à une température inférieure à 450°C, cette réaction consistant à réduire les oxydes natifs, à éliminer les impuretés telles que le carbone et à reconstituer la composition stoechiométrique du matériau III - V par recombinaison de l'arsenic en surface, en ce que l'étape de dépôt de nitrure de silicium par plasma est précédée par une étape de formation d'une couche mince de nitrure d'arsenic et de gallium par plasma d'azote (N₂), cette couche servant de couche de passivation, et en ce que toutes les étapes incluant des plasmas sont réalisées dans une même enceinte et contrôlées sans sortir l'échantillon de l'enceinte.

2. Procédé selon la revendication 1, caractérisé en ce que le matériau III-V est l'arséniure de gallium.

3. Procédé selon la revendication 2, caractérisé en ce que le composé gazeux d'hydrogène et d'arsenic est un mélange d'hydrogène et d'arsine (H₂ + AsH₃), dans lequel la quantité d'arsine est inférieure à, ou de l'ordre de 1 % en volume, et en ce que l'action de ce plasma sur la surface d'arséniure de gallium est pratiquée à environ 380°C.

4. Procédé selon la revendication 3, caractérisé en ce que la couche de nitrure d'arsenic et de gallium est réalisée sur une épaisseur d'environ 2.10⁻³ μm par l'action du plasma d'azote (N₂).

5. Procédé selon l'une des revendications 1 à 4, caractérisé en ce que la couche de nitrure de silicium est obtenue par l'action d'un plasma de silane et d'azote (SiH₄ + N₂).

6. Procédé selon la revendication 5, dans la mesure où elle dépend de la revendication 2, caractérisé en ce que pour réaliser des transistors, le substrat en arséniure de gallium est semi-isolant et muni d'une région active par implantation d'ions silicium suivie d'un recuit, en ce qu'il comprend appliquées à ce substrat ainsi préparé l'étape de traitement de surface par plasma d'hydrogène et d'arsenic, puis l'étape de formation d'une couche mince de nitrure d'arsenic et de gallium par plasma d'azote; puis l'étape de dépôt de nitrure de silicium par plasma, ces trois étapes étant réalisées dans la même enceinte sans sortir l'échantillon de l'enceinte, et en ce qu'il comprend ensuite les étapes supplémentaires de:

– ouverture dans les couches de nitrure d'arsenic et de gallium et de niture de silicium de zones permettant de graver la couche active, et d'isoler ainsi chaque transistor à réaliser, par formation de mesas;
– ouverture dans lesdites couches de nitrure, sur chaque mesa, de zones pour les contacts ohmiques de source et drain ;
- réalisation de ces contacts par évaporation d'or et de germanium puis formation de l'alliage or-germanium;
- ouverture dans lesdites couches de nitrure d'une zone de grille et évaporation dans cette zone d'un métal propre à former le contact de grille, par exemple l'aluminium, et en ce que les régions séparant les contacts de source, grille et drain des transistors restent couvertes par lesdites couches de nitrure pendant toutes ces étapes supplémentaires.

7. Procédé selon la revendication 5, dans la mesure où elle dépend de la revendication 2, caractérisé en ce que, pour réaliser des transistors de puissance, le substrat en arséniure de gallium est semi-isolant et muni d'une région active par implantation d'ions silicium suivie d'un recuit, en ce qu'il comprend appliquées à ce substrat ainsi préparé, des étapes selon lesquelles des mesas portant des contacts de source, grille et drain sont réalisés directement en surface de la région active, en ce qu'il comprend, appliquées aux transistors ainsi élaborés, l'étape de traitement de surface par plasma d'hydrogène et d'arsenic, puis l'étape de formation d'une couche mince de nitrure d'arsenic et de gallium par plasma d'azote, puis l'étape de dépôt de nitrure de silicium par plasma, ces trois étapes étant réalisées dans la même enceinte sans sortir l'échantillon de l'enceinte, et en ce qu'il comprend à la suite une étape d'ouverture desdites couches de nitrure dans les zones de contact électrique.

**Patentansprüche**

1. Verfahren zur Herstellung einer Halbleiteranordnung, wobei dieses Verfahren zunächst aus einem Schritt besteht zur Plasmabehandlung einer Oberfläche eines Substrats aus einem Material III - V, das mindestens Arsen und Gallium aufweist, und weiterhin aus einem Niederschlagschritt ebenfalls mittels eines Plasmas auf der behandelten Oberfläche, wobei dieser Niederschlag aus einer Siliziumnitridschicht ($Si_3N_4$) besteht, *dadurch gekennzeichnet*, daß in dem Oberflächenbehandlungsschritt mittels eines Plasmas die Plasmabehandlung durch die Reaktion eines aus Wasserstoff und Arsen gebildeten Gasgefüges bei einer Temperatur unter 450°C erhalten wird, wobei diese Reaktion daraus besteht, die ursprünglichen Oxide zu verringern, die Verunreinigungen wie Kohlenstoff zu eliminieren und die stöchiometrische Zusammensetzung des Materials III - V durch Rekombination des Arsens in der Oberfläche zu rekonstruieren, daß der Siliziumnitrid-Niederschlag durch Plasma einem Bildungsschritt einer dünnen Arsen- und Galliumnitrid-Schicht durch Stickstoffplasma ($N_2$) folgt, wobei diese Schicht als Passivierungsschicht wirksam ist und daß alle Schritte mit Plasma in ein und demselben Raum durchgeführt und kontrolliert werden, ohne daß die Probe den Raum verläßt.

2. Verfahren nach Anspruch 1 *dadurch gekennzeichnet*, daß das Material III - V Galliumarsenid ist.

3. Verfahren nach Anspruch 2, *dadurch gekennzeichnet*, daß das Wasserstoff-Arsen-Gasgefüge ein Gemisch aus Wasserstoff und Arsen ist ($H_2$ + $AsH_3$), wobei die Menge Arsen kleiner ist als oder gleich 1 Vol.-% ist, und daß die Auswirkung des Plasmas auf die Gallium-ArsenidOberfläche bei etwa 380°C durchgeführt wird.

4. Verfahren nach Anspruch 3, *dadurch gekennzeichnet*, daß die Gallium-Arsen-Nitridschicht mit einer Dicke von etwa $2.10^{-3}$ µm durch die Wirkung des Stickstoffplasmas ($N_2$) gebildet wird.

5. Verfahren nach einem der Ansprüche 1 bis 4, *dadurch gekennzeichnet*, daß die Siliziumnitridschicht durch die Wirkung eines Silan- und Stickstoffplasmas ($SiH_4$ + $N_2$) erhalten wird.

6. Verfahren nach Anspruch 5, insofern von Anspruch 2 abhängig, *dadurch gekennzeichnet*, daß zur Herstellung von Transistoren das Gallium-Arsenid-Substrat halbisolierend und mit einem aktiven Gebiet versehen ist durch Implantierung von Siliziumionen mit einer nachfolgenden Glühbehandlung, daß an diesem auf diese Weise vorbereiteten Substrat der Oberflächenbehandlungsschritt durch Plasma von Wasserstoff und Arsen durchgeführt wird, sowie der Verfahrensschritt zum Bilden einer dünnen Arsen- und Galliumnitrid-Schicht durch Plasma von Stickstoff, sowie der Verfahrensschritt zum Niederschlagen von Siliziumnitrid durch Plasma, wobei diese drei Verfahrensschritte in ein und demselben Raum durchgeführt werden, ohne daß die Probe den Raum verläßt, und daß das Verfahren weiterhin die zusätzlichen Schritte umfaßt:

- das Öffnen in den Arsen- und Galliumnitrid- sowie Siliziumnitrid-Schichten von Zonen zum Einschneiden der aktiven Schicht und zum Isolieren jedes herzustellenden Transistors durch die Bildung von Mesas;
- das Öffnen in den genannten Nitridschichten, auf jedem Mesa, von Zonen für die ohmschen Source- und DrainKontakte;
- das Herstellen dieser Kontakte durch Gold- und Germanium-Aufdampfung mit nachfolgender Bildung einer Gold-Germanium-Legierung;
- das Öffnen in den genannten Nitrid-Schichten einer Gate-Zone und das Aufdampfen in dieser Zone eines Metalls, das dazu geeignet ist, den Gate-Kontakt zu bilden, beispielsweise Aluminium,

und daß die Gebiete, welche die Source-, Gate- und Drain-Kontakte der Transistoren voneinander trennen während der ganzen zusätzlichen Verfahrensschritte durch die genannten Nitrid-Schichten bedeckt bleiben.

11

7. Verfahren nach Anspruch 5, insofern abhängig von Anspruch 2, *dadurch gekennzeichnet,* daß zum Herstellen von Leistungstransistoren das Galliumarsenid-Substrat halbisolierend und mit einem aktiven Gebiet versehen ist durch Implantation von Siliziumionen mit einer nachfolgenden Glühbehandlung, daß an dem auf diese Weise behandelten Substrat Verfahrensschritte durchgeführt werden, durch die Mesas mit Source-, Gate- und Drain-Kontakten unmittelbar auf der Oberfläche des aktiven Gebieten hergestellt werden, daß an den auf diese Weise verwirklichten Transistoren der Verfahrensschritt der Oberflächenbehandlung, danach der Verfahrensschritt der Bildung einer dünnen Arsen- und Galliumnitrid-Schicht durch Stickstoffplasma, dann der Verfahrensschritt des Siliziumnitrid-Niederschlags durch Plasma durchgeführt wird, wobei diese drei Verfahrensschritte in ein und demselben Raum durchgeführt werden, ohne daß die Probe den Raum verläßt, und daß das Verfahren danach einen Verfahrensschritt aufweist zum Öffnen der genannten Nitrid-Schichten in den elektrischen Kontaktzonen.

**Claims**

1. A method of manufacturing a semiconductor device, which method comprises first a step of surface treatment by plasma of a substrate of a III - V material comprising at least arsenic and gallium and then a step of deposition also by plasma on the treated surface of a layer of silicon nitride (Si₃N₄), characterized in that in the step of surface treatment by plasma, this surface treatment by plasma is obtained by the reaction of the gaseous compound formed from hydrogen and arsenic at a temperature lower than 450°C, this reaction consisting in reducing the native oxides, in eliminating contaminations, such as carbon, and in recovering the stoichiometric composition of the III - V material by recombination of arsenic at the surface, in that the step of deposition of silicon nitride by plasma is preceded by a step of forming a thin layer of arsenic and gallium nitride by plasma of nitrogen (N₂), this layer serving as a passivation layer, and in that all the steps including plasma are effected in the same space and are controlled without taking the sample out of the space.

2. A method as claimed in Claim 1, characterized in that the III - V material is gallium arsenide.

3. A method as claimed in Claim 2, characterized in that the gaseous compound of hydrogen and arsenic is a mixture of hydrogen and arsine (H₂ + AsH₃), in which the quantity of arsine is smaller than or of the order of 1 % by volume, and in that the action of this plasma on the surface of gallium arsenide takes place at about 380°C.

4. A method as claimed in Claim 3, characterized in that the layer of arsenic and gallium nitride is formed over a thickness of about $2.10^{-3}$ μm by

12

the action of the plasma of oxygen (N₂).

5. A method as claimed in any one of Claims 1 to 4, characterized in that the layer of silicon nitride is obtained by the action of a plasma of silane and nitrogen (SiH₄ + N₂).

6. A method as claimed in Claim 5, as far as dependent upon Claim 2, characterized in that, in order to obtain transistors, the substrate of gallium arsenide is semiinsulating and is provided with an active region by implantation of silicon ions followed by an annealing treatment; in that it comprises, applied to this substrate thus prepared, the step of surface treatment by plasma of hydrogen and arsenic and then the step of forming a thin layer of arsenic and gallium nitride by plasma of nitrogen and subsequently the step of depositing silicon nitride by plasma, these three steps being effected in the same space without taking the sample out of the space, and in that it then comprises the supplementary steps of:

- exposing in the layers of arsenic and gallium nitride and of silicon nitride zones permitting of etching the active layer and thus insulating each transistor to be formed by formation of mesas;
- exposing in the said nitride layers on each mesa zones for the ohmic source and drain contacts;
- forming these contacts by evaporation of gold and germanium and then forming the gold-germanium-alloy;
- exposing in the said nitride layers a gate zone and evaporating in this zone a metal suitable to form the gate contact, for example aluminium, and in that the regions separating the source, and drain contacts of the transistors remain covered by the said nitride layers during all these supplementary steps.

7. A method as claimed in Claim 5, as far as dependent upon Claim 2, characterized in that, in order to obtain power transistors, the substrate of gallium arsenide is semiinsulating and is provided with an active region by implantation of silicon ions followed by an annealing treatment, in that it comprises, applied to this substrate thus prepared, steps in which mesas carrying source, gate and drain contacts are formed directly at the surface of the active region, in that it comprises, applied to the transistors thus processed, the step of surface treatment by plasma of hydrogen and arsenic, then the step of forming a thin layer of arsenic and gallium nitride by plasma of nitrogen, and then the step of depositing silicon nitride by plasma, these three steps being carried out in the same space without taking the sample out of the space, and in that it comprises subsequently a step of exposing the said nitride layers in the electrical contact zones.

FIG.1

EP 0 180 268 B1

FIG.2a

FIG.3a

FIG.2b

FIG.3b

FIG.2c

FIG.3c

FIG.3d

3

FIG.4